# EUROPEAN PATENT APPLICATION

(11) **EP 1 814 165 A1**
(43) Date of publication of application: **01.08.2007**
(21) Application number: 07001975.7
(22) Date of filing: 30.01.2007
(51) Int. Cl.: H01L 33/00, H01L 25/075

(54) **Semiconductor device and method of manufacturing semiconductor device**

(30) Priority: 30.01.2006 JP 2006020947
(71) Applicant: SHINKO ELECTRIC INDUSTRIES CO., LTD., Nagano-shi, Nagano 381-2287 (JP)
(72) Inventor: Shiraishi, Akinori, Nagano-shi Nagano 381-2287 (JP); Koizumi, Naoyuki, Nagano-shi Nagano 381-2287 (JP); Murayama, Kei, Nagano-shi Nagano 381-2287 (JP); Sakaguchi, Hideaki, Nagano-shi Nagano 381-2287 (JP); Sunohara, Masahiro, Nagano-shi Nagano 381-2287 (JP); Taguchi, Yuichi, Nagano-shi Nagano 381-2287 (JP); Higashi, Mitsutoshi, Nagano-shi Nagano 381-2287 (JP)
(74) Representative: Zimmermann & Partner

(57) **Abstract**

A semiconductor device 10 has such a structure that a plurality of through electrodes 30 is formed on a substrate 20 and each of terminals of light emitting devices (LEDs) 40 is electrically connected to each of the through electrodes 30 via a bump 50 on a lower surface side. In the semiconductor device 10, moreover, a partition wall 80 for surrounding a mounting region of each of the light emitting devices 40 is formed on the substrate 20. The partition wall 80 is formed by laminating a metal film (Cu) using a thin film forming method such as a plating method. Furthermore, the partition wall 80 is formed to be opposed close to each of side surfaces of the light emitting devices 40 and is provided to surround each of the light emitting devices 4

## Description

The present disclosure relates to a semiconductor device and a method of manufacturing the semiconductor device. More particularly, the present disclosure relates to an improvement in a semiconductor device which mounts a plurality of devices on a substrate at a high density and a method of manufacturing the semiconductor device.

In recent years, there has increasingly been developed an illuminating apparatus and a display apparatus which uses a light emitting device (LED: light emitting diode) as a light source. Consequently, it has been demanded that a plurality of light emitting devices are to be mounted at a high density. In particular, the light emitting device is a minute chip manufactured by using a micromachining technique in the same manner as a semiconductor chip. For example, it has been investigated to increase a light intensity in a light emission by mounting a plurality of light emitting devices in an area of several millimeters.

For example, a light emitting device formed by a blue LED is fabricated by using a translucent sapphire substrate as a base member to laminate P and N layers, and a part of a light irradiated from a boundary portion between the P and N layers leaks out of a side surface and a bottom face of the sapphire substrate. In the case in which a plurality of light emitting devices are disposed on the same substrate, there is a problem in that a light irradiated from a side surface of a neighboring light emitting device is absorbed into a sapphire substrate of an adjacent light emitting device because the sapphire substrate has such a property as to absorb a light, and an intensity of a light irradiated from the light emitting device toward an outside is thus reduced.

As a method of solving the problem, for example, there is a method of forming a trapezoidal concave portion on a substrate and plating a surface of the substrate with a metal, thereby mounting a light emitting device in the concave portion (for example, see Japanese Patent Unexamined Publication No. 2002-344031).

However, a semiconductor device according to JP-2002-344031 has such a structure that a light emitting device is mounted in a concave portion having a metal plated layer formed thereon and a light emitted from the light emitting device is thus reflected by a slant face of the metal plated layer, thereby concentrating a direction of irradiation of the light above a substrate. However, there is a problem in that an interval between the light emitting devices is increased and it is hard to mount the light emitting devices at a high density.

In light of the above, the semiconductor device according to independent claim 1, the method of manufacturing a semiconductor device according to independent claims 4 and 7 are provided.
Further advantages, features, aspects and details of the invention are evident from the dependent claims, the description and the drawings.
Embodiments of the present invention provide a semiconductor device and a method of manufacturing the semiconductor device.

One or more embodiments of the invention have the following means.

One or more embodiments of the invention provides a semiconductor device in which a plurality of light emitting devices is mounted on a substrate, wherein a partition wall for intercepting a light between the light emitting devices is provided in the vicinity of a mounting region in which the light emitting devices are mounted.

Moreover, the partition wall is formed perpendicularly on the substrate so as to be opposed close to a side surface of the light emitting device.

Furthermore, one or more embodiments of the invention provides a method of manufacturing a semiconductor device which mounts a plurality of light emitting devices on a substrate, comprising the steps of forming through electrodes in a plurality of portions in which the light emitting devices are disposed on the substrate, forming a seed layer on a surface of the substrate so as to be connected to the through electrodes, patterning a resist in a mounting region in which the light emitting devices are mounted, forming a partition wall for intercepting a light between the light emitting devices around the mounting region, removing the resist from the substrate, and disposing the light emitting devices in the mounting region.

The partition wall has a metal film laminated by a thin film forming method in the vicinity of a side surface of the light emitting device.

The partition wall has such a structure that a metal layer formed by plating is laminated to surround a side surface of the light emitting device.

Moreover, one or more embodiments of the invention provides a method of manufacturing a semiconductor device which mounts a plurality of light emitting devices on a substrate, comprising the steps of forming a plurality of concave portions in a region on a surface of the substrate in which the light emitting devices are to be mounted, thereby leaving a partition wall between the concave portions, forming through electrodes in bottom parts of the concave portions, mounting the light emitting devices in the concave portions, and connecting terminals of the light emitting devices to the through electrodes.

The concave portion is formed to take a corresponding shape to a contour shape of the light emitting device.

The concave portion is formed by etching and an internal wall of the concave portion opposed close to a side surface of the light emitting device is formed as a partition wall.

The light emitting device is an LED formed by using sapphire as a substrate.

According to one or more embodiments of the invention, the partition wall for intercepting a light between the light emitting devices is provided in the vicinity of the mounting region in which the light emitting devices are to be mounted. Therefore, it is possible to prevent a light intensity from being reduced by a light absorption between the light emitting devices, and furthermore, to mount the light emitting devices at a high density.

According to one or more embodiments of the invention, moreover, it is possible to reduce the interval between the light emitting devices by thinning the partition wall. Consequently it is possible to provide the light emitting devices densely to increase a mounting number per unit area, thereby enhancing a light intensity of the light emitting devices.
Embodiments are also directed to methods by which the described apparatus operates or by which the described apparatus is manufactured. It may include method steps for carrying out every function of the apparatus or manufacturing every part of the apparatus. These method steps may be performed by way of hardware components, a computer programmed by appropriate software, by any combination of the two or in any other manner.
Other features and advantages may be apparent from the following detailed description, the accompanying drawings and the claims.

Fig. 1 is a view showing a semiconductor device according to a first embodiment in accordance with the invention,
Fig. 2A is a view showing a method of manufacturing a semiconductor device according to the first embodiment (No. 1),
Fig. 2B is a view showing the method of manufacturing a semiconductor device according to the first embodiment (No. 2),
Fig. 2C is a view showing the method of manufacturing a semiconductor device according to the first embodiment (No. 3),
Fig. 2D is a view showing the method of manufacturing a semiconductor device according to the first embodiment (No. 4),
Fig. 2E is a view showing the method of manufacturing a semiconductor device according to the first embodiment (No. 5),
Fig. 2F is a view showing the method of manufacturing a semiconductor device according to the first embodiment (No. 6),
Fig. 2G is a view showing the method of manufacturing a semiconductor device according to the first embodiment (No. 7),
Fig. 2H is a view showing the method of manufacturing a semiconductor device according to the first embodiment (No. 8),
Fig. 2I is a view showing the method of manufacturing a semiconductor device according to the first embodiment (No. 9),
Fig. 2J is a view showing the method of manufacturing a semiconductor device according to the first embodiment (No. 10),
Fig. 2K is a view showing the method of manufacturing a semiconductor device according to the first embodiment (No. 11),
Fig. 3 is a view showing a semiconductor device according to a second embodiment,
Fig. 4A is a view showing a method of manufacturing a semiconductor device according to the second embodiment (No. 1),
Fig. 4B is a view showing the method of manufacturing a semiconductor device according to the second embodiment (No. 2),
Fig. 4C is a view showing the method of manufacturing a semiconductor device according to the second embodiment (No. 3),
Fig. 4D is a view showing the method of manufacturing a semiconductor device according to the second embodiment (No. 4),
Fig. 4E is a view showing the method of manufacturing a semiconductor device according to the second embodiment (No. 5),
Fig. 4F is a view showing the method of manufacturing a semiconductor device according to the second embodiment (No. 6),
Fig. 4G is a view showing the method of manufacturing a semiconductor device according to the second embodiment (No. 7),
Fig. 4H is a view showing the method of manufacturing a semiconductor device according to the second embodiment (No. 8),
Fig. 4I is a view showing the method of manufacturing a semiconductor device according to the second embodiment (No. 9), and
Fig. 4J is a view showing the method of manufacturing a semiconductor device according to the second embodiment (No. 10),
Fig. 5 is a view showing a semiconductor device according to a modified example of the first embodiment.

The best mode for carrying out the invention will be described below with reference to the drawings.

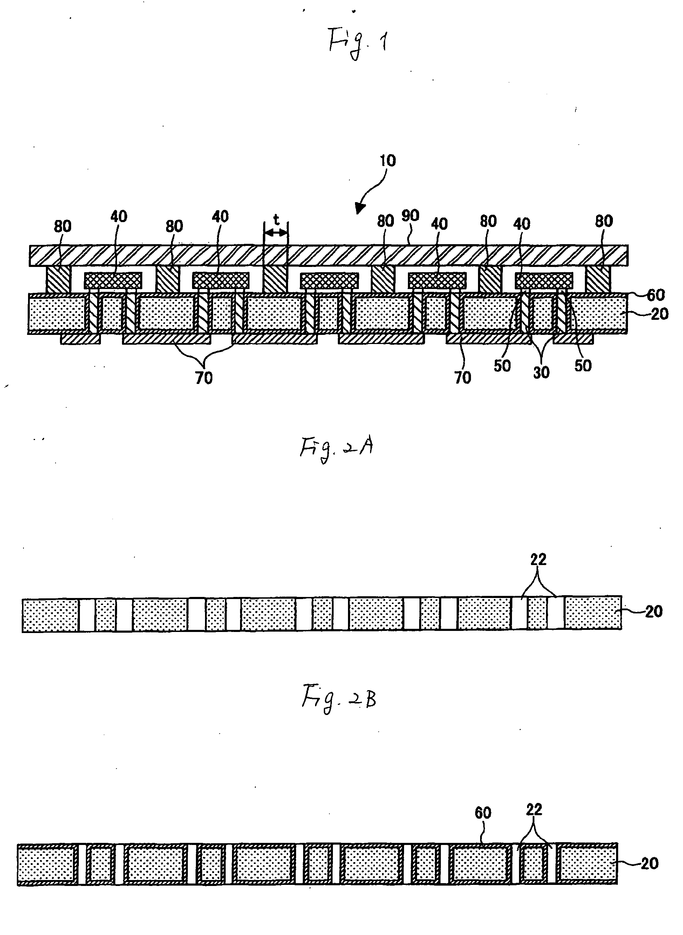

Fig. 1 is a view showing a semiconductor device according to a first embodiment in accordance with the invention. As shown in Fig. 1, a semiconductor device 10 has such a structure that a plurality of through electrodes 30 formed of Cu are provided on a substrate 20 formed of Si and each of terminals of light emitting devices (LEDs) 40 is electrically connected to each of the through electrodes 30 via a bump (Au bump) 50 formed of Au which is provided on a lower surface side. Moreover, an insulating film 60 is formed on a surface of the substrate 20, and a lower surface side of the substrate 20 is provided with a wiring pattern 70 which is electrically connected to the through electrode 30.
In the semiconductor device 10, moreover, a partition wall 80 is formed between the light emitting devices 40. Furthermore, a transparent glass plate 90 is bonded to an upper surface of the partition wall 80 and an internal space of the partition wall 80 is thus sealed.

For example, the partition wall 80 is formed by laminating a metal layer (Cu) using a thin film forming method such as a plating method. While only a section of the partition wall 80 is shown in Fig. 1, moreover, the partition wall 80 is formed to be opposed close to each of side surfaces of the light emitting devices 40 and is provided to surround each of the light emitting devices 40. More specifically, the partition wall 80 is formed like a gird having a square internal wall so as to be opposed close to side surfaces in four directions of the light emitting device 4 as seen from above. Therefore, light irradiated from the side surfaces of each of the light emitting device 4 is intercepted by the partition wall 80.

The light emitting device 40 is an LED formed by using sapphire as a base material and has such a structure that a P layer, an N layer and an electrode are laminated on a translucent sapphire substrate. When a voltage is applied to each of the terminals in the light emitting device 40, therefore, a light is emitted from a boundary between the P and N layers so that a light having a predetermined light emitting color is irradiated. In the light emitting devices 40, moreover, a light leaks out of side and bottom faces of the sapphire substrate in the light emission. However, the light is intercepted by the partition wall 80. Therefore, the light can be prevented from being absorbed between the light emitting devices 40.

In the case in which the partition wall 80 is formed by a glossy metal layer, furthermore, the surface of the partition wall 80 also functions as a reflecting plane for reflecting a light. In that case, the light leaking out of the side surface of the light emitting device 40 is reflected by the partition wall 80 and is thus absorbed into the light emitting device 40. Therefore, an intensity of a light irradiated upward from the light emitting device 40 can be prevented from being reduced.

Moreover, the partition wall 80 is formed to have a perpendicular wall surface on an upper surface of the substrate 20. By decreasing a thickness t in a horizontal direction as shown in Fig. 1, therefore, it is possible to reduce an interval between the light emitting devices 40. Consequently, the light emitting devices 40 can be mounted at a high density by decreasing the thickness t of the partition wall 80.

Thus, the light emitting devices 40 are mounted in a dense state so that an apparent light emitting area can be increased. Therefore, the intensity of the light irradiated from the semiconductor device 10 is increased.

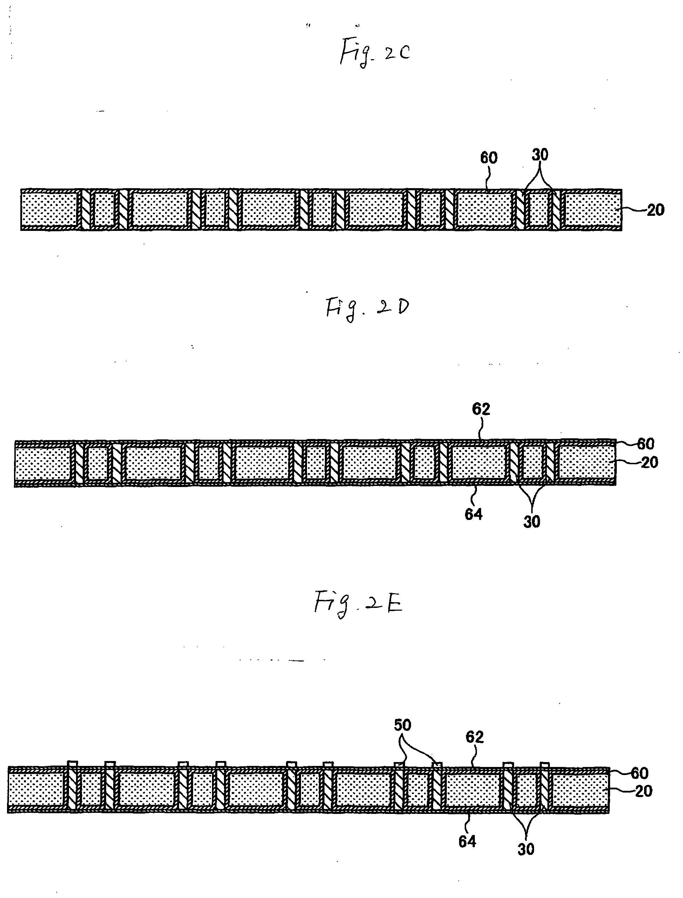

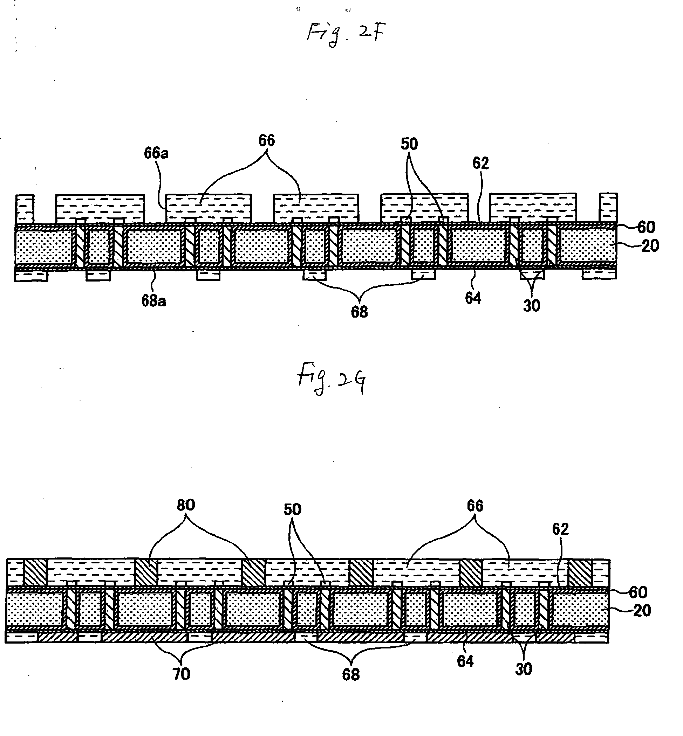

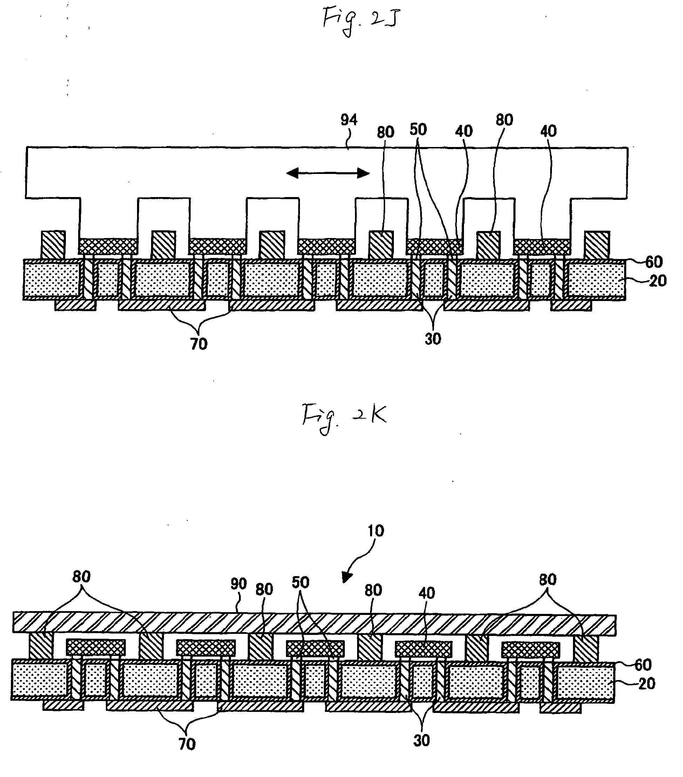

Next, an example of a method of manufacturing the semiconductor device 10 will be described in order with reference to Figs. 2A to 2K. In the following drawings, the portions described above have the same reference numerals and description thereof will be omitted.

First of all, at a step shown in Fig. 2A, the silicon substrate 20 is etched and patterned to form a through hole (a via hole) 22 penetrating the silicon substrate 20 in order to provide the through electrode (a via plug) 30.

As a step shown in Fig. 2B, then, the insulating film 60 constituted by an oxide film (which is also referred to as a silicon oxide film or a thermal oxide film) is formed on the surface of the silicon substrate 20 including an internal wall surface of the through hole 22 by a thermal CVD (Chemical vapor deposition) method, for example.

At a step shown in Fig. 2C, thereafter, the through electrode 30 is formed in each through hole 22 by a Cu plating method (such as a semiadditive method), for example.

At a step shown in Fig. 2D, subsequently, seed layers 62 and 64 formed of a conductive metal such as Cu are laminated on upper and lower surfaces of the insulating film 60.

As a step shown in Fig. 2E, next, a connecting layer (not shown) formed of Ni/Au, for example, and a bump (Au bump) 50 on the connecting layer are formed by a plating method using the seed layer 62 to be a power supply layer, for example.

At a step shown in Fig. 2F, then, resist patterns 66 and 68 are formed by patterning a dry film resist or a coated resist film on surfaces of the seed layers 62 and 64 and the bump 50, for example. A thickness of the resist 66 on an upper side corresponds to a height of the partition wall 80 and is set to be higher than a vertical position of the upper surface of the light emitting device 40.

Moreover, a concave portion 66a is formed in a region in which the partition wall 80 is to be provided in the resist layer 66 on an upper surface side, that is, a region provided on an outside of a region in which the light emitting device 40 is to be mounted. Moreover, a concave portion 68a is formed in a region in which the wiring pattern 70 is to be formed of the resist layer 68 at a low surface side. The concave portions 66a and 68a may be formed by patterning through screen printing or a process for forming a photosensitive resist by a photographic method may be used.

At a step shown in Fig. 2G, thereafter, a metal such as Cu is deposited on the concave portion 66a of the resist layer 66 by the plating method (for example, the semiadditive method) using the seed layer 62 on the upper surface side as a power supply layer and a metal film is thus provided. Consequently, the partition wall 80 having a perpendicular wall surface is formed on the substrate 20. The partition wall 80 may be formed by using a thin film forming method other than the plating (for example, a sputtering method or a CVD method).

Furthermore, a conductive metal such as Cu is deposited on the concave portion 68a of the resist layer 68 by a plating method using the seed layer 64 on the lower surface side as a power supply layer so that the wiring pattern 70 is formed.

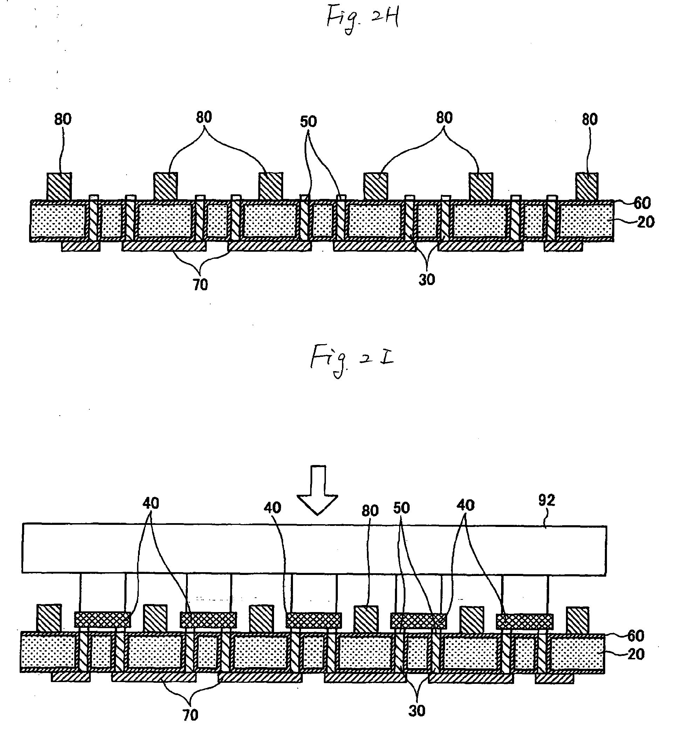

At a step shown in Fig. 2H, next, the resist layers 66 and 68 are removed from the substrate 20 by using an alkaline solution, for example. After Fig. 2H, the seed layers 62 and 64 are omitted.

At a step shown in Fig. 2I, subsequently, each light emitting device 40 adsorbed into a vacuum adsorbing portion 92 is delivered and mounted in a mounting region formed on an inside of the partition wall 80. Herein, the light emitting devices 40 are stuck to an adhesive tape, and then are absorbed into the vacuum adsorbing portion 92 for being delivered. The vacuum adsorbing portion 92 may have such a structure as to adsorb the light emitting devices 40 in a batch or to adsorb and deliver the light emitting devices 40 one by one.

At a step shown in Fig. 2J, then, a horn 94 of a bonder apparatus (not shown) for ultrasonic bonding is caused to abut on the upper surface of the light emitting device 40 and is brought into a pressurizing state, and a vibration caused by ultrasonic waves generated by means of a vibrator (not shown) is propagated to the light emitting device 40. Consequently, each terminal formed on each of the lower surfaces of the light emitting devices 40 is bonded to the through electrode 30 via the bump 50.

At a step shown in Fig. 2K, next, the glass plate 90 is mounted on the upper surfaces of the partition wall 80, and the partition wall 80 is bonded to the glass plate 90. For example, in the case in which the partition wall 80 is bonded to the glass plate 90 through anode bonding, a bonding layer (not shown) constituted by silicon is formed on the partition wall 80 by sputtering and a high voltage is applied to a portion between the bonding layer and the glass plate 90, and a predetermined rise in a temperature is carried out to bond the glass plate 90 to the partition wall 80. Consequently, the internal space of the partition wall 80 in which the light emitting device 40 is mounted is sealed with the glass plate 90.

In the example, 1, thus, the partition wall 80 opposed close to the side surfaces of the light emitting devices 40 is formed around the light emitting devices 40 by the film forming method such as the plating method. Consequently, it is possible to intercept a light emitted from the side surface of the light emitting device 40 by means of the partition wall 80 and to prevent the light from being absorbed between the adjacent light emitting devices 40. The light reflected by the perpendicular wall surface of the partition wall 80 over the substrate 20 is returned to the light emitting device 40. Therefore, it is possible to suppress a reduction in the intensity of the light irradiated upward from the light emitting device 40. By decreasing the thickness t of the partition wall 80, furthermore, it is possible to reduce the interval between the light emitting devices 40. Therefore, the mounting can be carried out at a higher density. By increasing the mounting number of the light emitting devices 40 per unit area on the substrate 20, it is possible to raise the intensity of the light which is obtained by the light emitting devices 40.

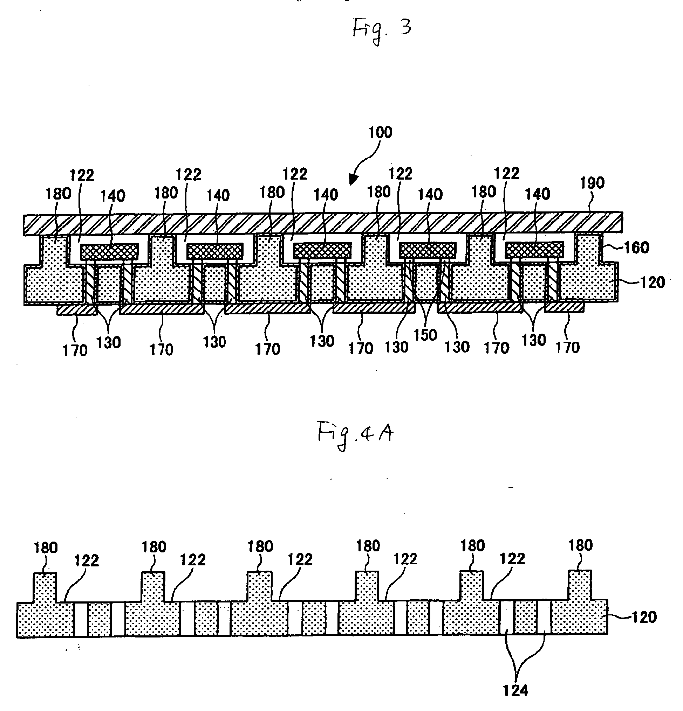

Fig. 3 is a view showing a semiconductor device 100 according to a second embodiment. As shown in Fig. 3, the semiconductor device 100 has such a structure as to have a silicon substrate (which will be hereinafter referred to as a "substrate") 120, a concave portion 122 formed on the substrate 120, a light emitting device 140 mounted in the concave portion 122, and a glass plate 190 and to bond an upper surface of a partition wall 180 surrounding the concave portion 122 to the glass plate 190, thereby sealing the concave portion 122.

The partition wall 180 is formed integrally with the substrate 120 and is provided in a predetermined position through an etching treatment which will be described below.

Moreover, the light emitting device 140 is electrically connected to a through electrode 130 formed to penetrate a bottom face of the substrate 120 through a bump (Au bump) 150 formed of Au, for example. Furthermore, a lower end of the through electrode 130 is connected to a wiring pattern 170 formed on a lower surface of the substrate 120.

In addition, an insulating film 160 formed by an oxide film (a silicon oxide film) is provided on a surface of the substrate 120, and the substrate 120 is insulated from the through electrode 130, the wiring pattern 170 and the bump 150, for example.

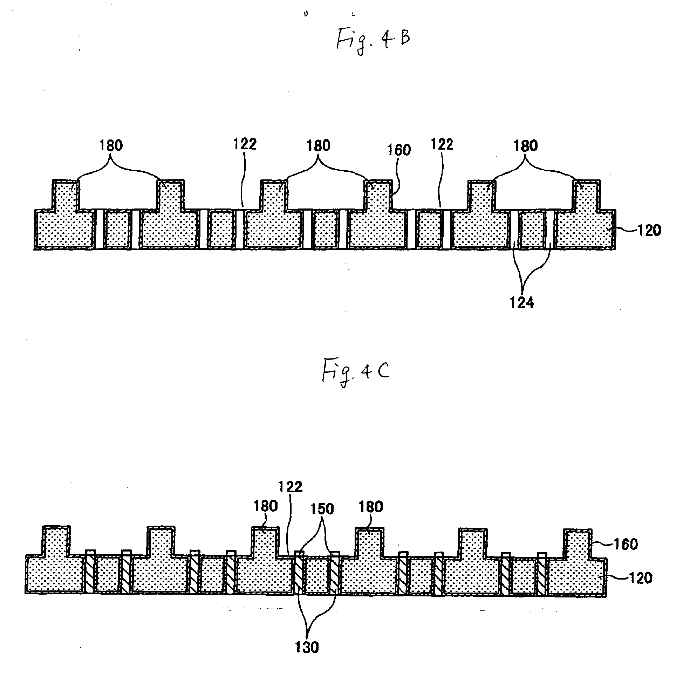

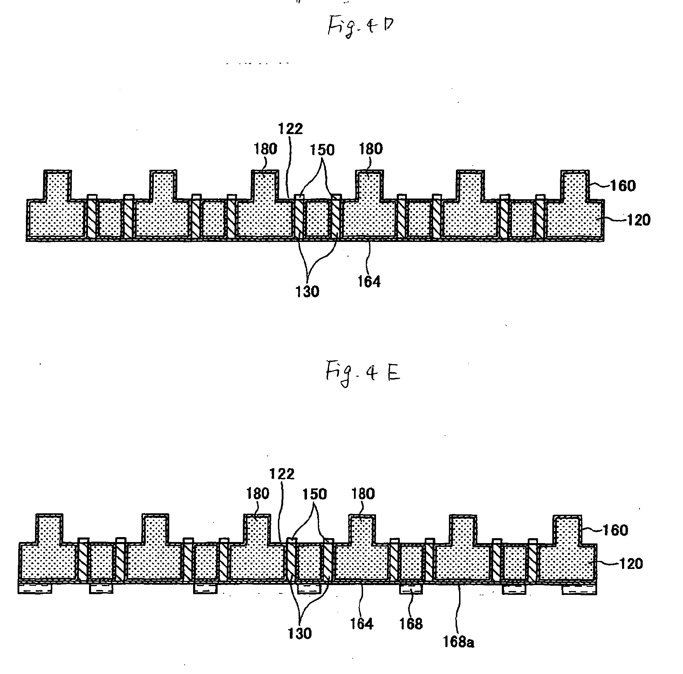

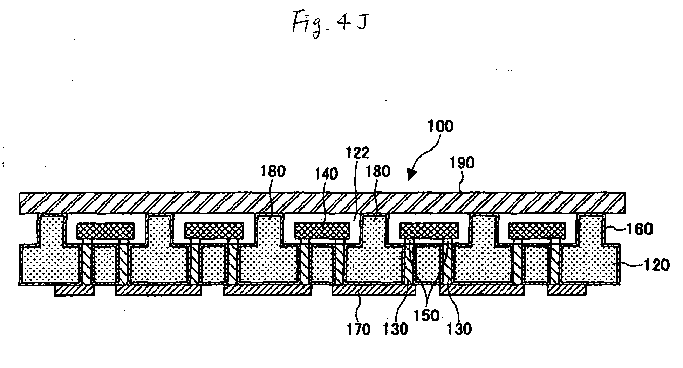

Next, an example of the method of manufacturing the semiconductor device 100 will be described in order with reference to Figs. 4A to 4J.

First of all, at a step shown in Fig. 4A, the substrate 120 is patterned by etching to form a plurality of concave portions 122 for disposing the light emitting device 140 and a plurality of through holes 124 penetrating the substrate 120. The concave portion 122 takes a square shape corresponding to a contour shape of a side surface of the light emitting device 140 as seen from above and is provided in a corresponding position to a mounting region in which the light emitting device 140 is to be mounted. Moreover, the concave portion 122 is formed to have a greater depth than the light emitting device 140 mounted on the bump 150.

By the formation of the concave portion 122, the partition wall 180 is left in a portion excluding the concave portion 122 on the substrate 120. The partition wall 180 has a perpendicular wall surface opposed close to each of side surfaces in four directions of the light emitting device 140.

At a step shown in Fig. 4B, next, the insulating film 160 formed by an oxide film (which will also be referred to as a silicon oxide film or a thermal oxide film) is provided on a surface of the silicon substrate 120 including an internal wall surface of the concave portion 122 and that of the through hole 124 by a thermal CVD (Chemical vapor deposition) method, for example.

At a step shown in Fig. 4C, then, the through electrode 130 is formed in each through hole 124 by a Cu plating method (such as a semiadditive method), for example. Furthermore, a solder is laminated on an upper end of the through electrode 130 to form a bump 150.

At a step shown in Fig. 4D, thereafter, a seed layer 164 formed of a conductive metal such as Cu is laminated on a lower surface of the insulating film 160 which is provided on a lower surface side of the substrate 120 by the plating method, for example.

At a step shown in Fig. 4E, subsequently, a dry film resist or a coated resist film is patterned to form a resist pattern 168 on a surface of the seed layer 164, for example.

At a step shown in Fig. 4F, next, a conductive metal such as Cu is deposited on a concave portion 168a of the resist layer 168 by a plating method using the seed layer 164 on the lower surface side as a power supply layer so that a wiring pattern 170 is formed.

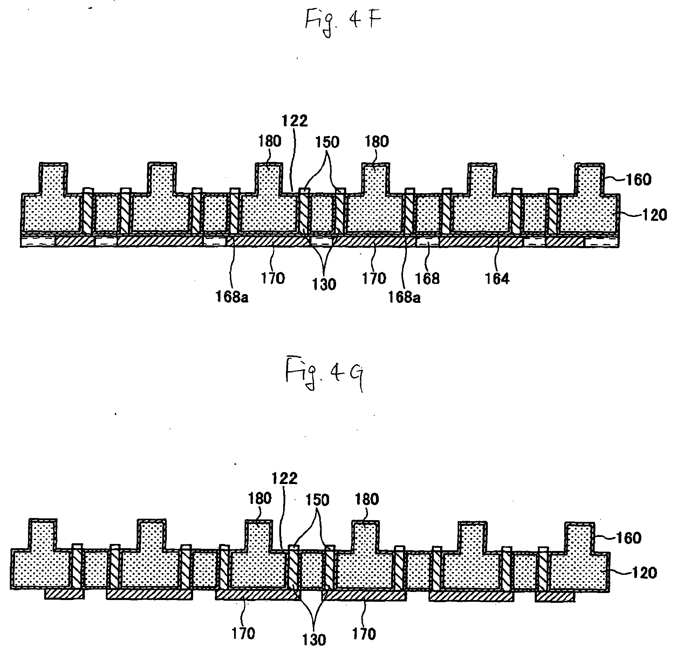

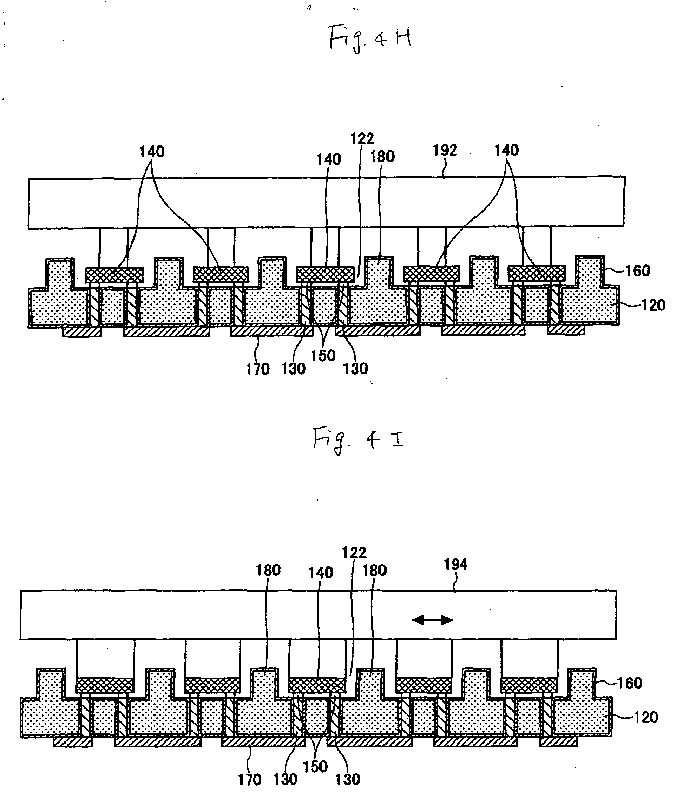

At a step shown in Fig. 4G, then, the resist layer 168 is removed from the substrate 120 by using an alkaline solution, for example. After Fig. 4G, the seed layer 164 is omitted.

At a step shown in Fig. 4H, thereafter, each light emitting device 140 adsorbed into a vacuum adsorbing portion 192 is delivered and mounted in the concave portion 122 (a mounting region) formed on an inside of the partition wall 180. The vacuum adsorbing portion 192 may have such a structure as to adsorb the light emitting devices 140 in a batch or to adsorb and deliver the light emitting devices 140 one by one.

At a step shown in Fig. 4I, subsequently, a horn 194 of a bonder apparatus for ultrasonic bonding (not shown) is caused to abut on the upper surface of the light emitting device 140 and is brought into a pressurizing state, and a vibration caused by ultrasonic waves generated by means of a vibrator (not shown) is propagated to the light emitting device 140. Consequently, each terminal formed on each of the lower surfaces of the light emitting devices 140 is bonded to the through electrode 130 via the bump 150.

At a step shown in Fig. 4J, next, a glass plate 190 is mounted on the upper surface of the partition wall 180, and the partition wall 180 is bonded to the glass plate 190. For example, in the case in which the partition wall 180 is bonded to the glass plate 190 through anode bonding, a bonding layer (not shown) constituted by silicon is formed on the partition wall 180 by sputtering and a high voltage is applied to a portion between the bonding layer and the glass plate 190, and a predetermined rise in a temperature is carried out to bond the glass plate 190 to the partition wall 180. Consequently, the internal space of the partition wall 180 in which the light emitting device 140 is mounted is sealed with the glass plate 190.

In the second embodiment, thus, the surface of the substrate 120 is etched to form the concave portion 122 in the mounting region of the light emitting device 140, thereby leaving the partition wall 180 around the mounting region. Thus, it is possible to form the partition wall 180 for intercepting a light from the side surface of the light emitting device 140 and to prevent the light from being absorbed between the adjacent light emitting devices 140 by the presence of the partition wall 180. The perpendicular wall surface of the partition wall 180 provided on the substrate 120 serves as a glossy reflecting surface formed on silicon. Therefore, a light reflected by the partition wall 180 is returned to the light emitting device 140 so that it is possible to suppress a reduction in an intensity of a light irradiated upward from the light emitting device 140. By decreasing a thickness t of the partition wall 180, furthermore, it is possible to reduce an interval between the light emitting devices 140. Therefore, the mounting can be carried out at a higher density. By increasing the mounting number of the light emitting devices 140 per unit area on the substrate 120, it is possible to raise the intensity of the light which is obtained by the light emitting devices 140.

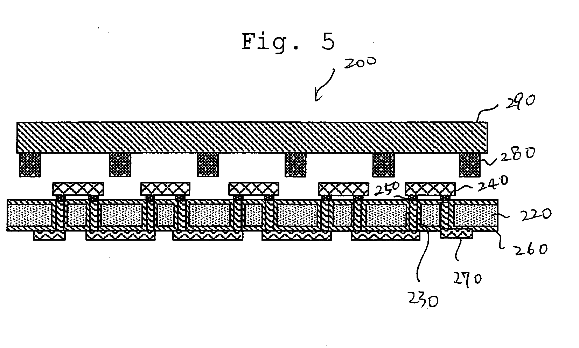

While the invention has been described above based on the preferred examples, the invention is not restricted to the specific examples but various deformations and changes can be made within the gist described in the claims.
In the first embodiment, the partition wall 80 is formed on the substrate 20 by the film forming method such as the plating method, and then the light emitting device 40 is mounted on the substrate 20. However, the present invention is not limited to this. For example, as shown in Fig. 5, a partition wall 280 is formed by forming a plurality of holes at positions corresponding to light emitting devices 240 in a metal plate. After the partition wall 280 is bonded to a glass plate 290, the partition wall 280 is attached to a substrate 220 on which the light emitting devices 240 are mounted. In a semiconductor device 200, a through electrode 230, a bump 250, an insulating film 260, and a wiring pattern 270 are formed by the same method as that of the first embodiment.

While the method of adsorbing the light emitting device 40 stuck to an adhesive tape to the vacuum adsorbing portion 92 has been taken as an example in the first embodiment, this is not restricted but it is also possible to use a method of simultaneously adsorbing the light emitting devices 40 from a tray on which the light emitting device 40 is previously mounted at an interval of an air sucking hole, for example, in place of the adhesive tape.

## Claims

1. A semiconductor device comprising:
a substrate (20; 120; 220);
a plurality of light emitting devices (40; 140; 240) mounted on the substrate; and
a partition wall (80; 180; 280) for intercepting a light between the light emitting devices, said partition being provided in the vicinity of a mounting region in which the light emitting devices are mounted.

2. The semiconductor device according to claim 1, wherein the partition wall is formed perpendicularly on the substrate so as to be opposed close to a side surface of the light emitting device.

3. The semiconductor device according to claim 1 or 2, wherein the light emitting device (40; 140; 240) is an LED formed by using sapphire as a substrate.

4. A method of manufacturing a semiconductor device which mounts a plurality of light emitting devices on a substrate (20; 120; 220), comprising the steps of:
forming through electrodes (30; 130; 230) in a plurality of portions in which the light emitting devices (40; 140; 240) are disposed on the substrate;
forming a seed layer on a surface of the substrate (20; 120; 220) so as to be connected to the through electrodes;
patterning a resist in a mounting region in which the light emitting devices are mounted;
forming a partition wall (80; 180; 280) for intercepting a light between the light emitting devices (40; 140; 240) around the mounting region;
removing the resist from the substrate; and
disposing the light emitting devices in the mounting region.

5. The method of manufacturing a semiconductor device according to claim 4, wherein the partition wall (80; 180; 280) has a metal film laminated by a thin film forming method in the vicinity of a side surface of the light emitting device.

6. The method of manufacturing a semiconductor device according to claim 4, wherein the partition wall has such a structure that a metal layer formed by plating is laminated to surround a side surface of the light emitting device (40; 140; 240).

7. A method of manufacturing a semiconductor device which mounts a plurality of light emitting devices on a substrate (120), comprising the steps of:
forming a plurality of concave portions (122) in a region on a surface of the substrate in which the light emitting devices are to be mounted, thereby leaving a partition wall (180) between the concave portions;
forming through electrodes (130) in bottom parts of the concave portions;
mounting the light emitting devices (140) in the concave portions; and
connecting terminals of the light emitting devices to the through electrode.

8. The method of manufacturing a semiconductor device according to claim 7, wherein the concave portion is formed to take a corresponding shape to a contour shape of the light emitting device.

9. The method of manufacturing a semiconductor device according to claim 7, wherein the concave portion is formed by etching and an internal wall of the concave portion opposed close to a side surface of the light emitting device is formed as a partition wall.

10. The method of manufacturing a semiconductor device according to any of claims 4 to 9, wherein the light emitting device is an LED formed by using sapphire as a substrate.
